# EUROPEAN PATENT SPECIFICATION

(11) **EP 0 910 233 B1**
(45) Date of publication and mention of the grant of the patent: **25.09.2002**
(21) Application number: 97308090.6
(22) Date of filing: 13.10.1997
(51) Int. Cl.: H05K 5/02, H05K 9/00

(54) **A shielded PC card and method of manufacture**
Eine abgeschirmte PC-Karte und deren Herstellungsverfahren
Carte PC blindée et sa fabrication

(43) Date of publication of application: 21.04.1999
(73) Proprietor: ITT MANUFACTURING ENTERPRISES, INC., Wilmington, Delaware 19801 (US)
(72) Inventor: Learmonth, Iain Thomas, Basingstoke, Hampshire RG25 2EL (GB)
(74) Representative: Ertl, Nicholas Justin

(56) References cited:
- DE-A- 1 441 114
- US-A- 5 005 106
- US-A- 5 323 299
- US-A- 5 339 222
- "TAKING A GOOD IDEA INTO PRODUCTION" ELECTRONIC ENGINEERING, vol. 68, no. 830, 1 February 1996, page EMC 8 XP000556581

## Description

The present invention relates to PC cards such as are used to provide additional circuitry for use with computers and other electrical equipment.

PC cards are becoming of increasing importance particularly for use in portable equipment such as lap top computers where they can provide for example modem/telephone, and additional memory capabilities. There are standard specifications known as PCMCIA specifications for such cards which define amongst other things the dimensions for such cards so that they are compatible with equipment conforming to the standards. One of the critical dimensions is the maximum thickness of the cards of 5mm which permits the card to be inserted into a receiving slot of an electrical equipment. Such cards, described as type II PC cards normally comprise a housing having top and bottom metallic covers a printed circuit board provided with circuit components contained within the housing and a connector at one end which is coupled to the circuitry on the circuit board and permits mating with a complimentary connector in an insertion slot of an electrical equipment (see US-A-5 339 222). The housing is intended to provide electrical screening against electrical radiation into, and out of the PC card.

The circuitry on printed circuit boards of PC cards often include a number of circuits which need to be shielded from each other to prevent cross coupling of interference due to electrical radiation e.g. R.F. circuitry. Such shielding is required to remain intact after mechanical flexing of the PC card which normally occurs in cards in use. The PSMCIA specification describes a 'Torque Test' K 'Bend Test' which cards must survive, to simulate this phenomenon. One way of providing shielding is to employ a number of shielding inner covers that fit over interfering circuitry which are coupled to a grounding track on the printed circuit board (see US-A-5 005 106). Such covers are unreliable due to their resistance to flexing and the risk of damage to the printed circuit during flexing of the PC card. One way we have tried to provide the shielding is to employ a conductive elastomer shaped to define a wall around circuitry to be screened which elastomer is sandwiched between a grounding track on the printed circuit board and a cover and compressed upon mutual securement of the covers to house the printed circuit board so that an electrical connection is made between the track and the housing through the elastomer screen. In this way the elastomer wall and the cover form an effective screen for the circuitry contained within the wall. A problem with this construction is that of providing sufficient compression force between the cover and the printed circuit board to ensure contact with good conductivity and it has been found that the PC card structure can not provide a stable compressive force. The covers although made of metal, typically stainless steel, necessarily have to be of thin material, in view of the restrictions on overall thickness of the card, so as to permit space for the printed circuit board and electrical components and even a low force can result in the covers becoming convex. The problem with this is that when the covers become convex the card thickness can easily be increased beyond the specified maximum thickness.

The present invention seeks to provide a solution to the previously mentioned problem.

According to the invention there is provided a PC card, comprising a housing having top and bottom metallic covers, a printed circuit board mounted in the housing and at least one flexible conductive shield provided between and in electrical contact with the board and one of the covers and secured by a conductive adhesive to one, or both, of the cover and a corresponding track on the printed circuit board.

The use of a conductive adhesive ensures that there is good electrical conductivity between the conductive shield and the grounding track and the cover, without requiring compressive force on the conductive shield or at least without such force as would distort the thin metallic covers. The construction also permits the shield to act as an accurate spacer to facilitate accurate thickness of the PC card to result.

The adhesive employed on at least one side of the or each shield may be releasable to permit opening of the PC card without damage to the printed circuit board or the shield. The adhesive employed on the opposite side of the or each shield may be a permanent non releasable type to maintain securement of the shield.

The or each shield may be formed from a conductive elastomer which may contain for example particles of silver to render it conductive. The or each shield may be moulded to define walls providing one or more enclosures for components on the board.

Preferably, at least one of the covers is built as a sandwich of a sheet metal layer a conductive adhesive and a metal foil. The metal foil may be copper.

According to another aspect of the invention there is provided a method of manufacturing a PC card according to claim 1 comprising the steps of securing the at least one flexible conductive shield to either, or both, of a corresponding track on the printed circuit board and one of the pair of top and bottom metallic covers of the housing by means of the conductive adhesive when installing the board in the housing.

The method may include the step of securing a similar flexible conductive shield to the other cover by means of a conductive adhesive so that the shield is disposed between the board and the other cover.

The method may include the prior step of moulding the or each shield to define walls to provide one or more enclosures for components on the board.

The method may include the additional steps of providing the conductive adhesive on both sides of a metal foil and securing the or each shield to the cover by attaching one adhesive side to one of the covers and the other adhesive side to the conductive shield.

In a particularly advantageous manufacturing environment the method may include the additional steps of releasably attaching the shields on a carrier liner strip from which they are transferred to a cover or printed circuit board-during manufacture.

In order that the invention and its various other preferred features may be understood more easily, some embodiments thereof will now be described, by way of example only, with reference to the drawings, in which
Figure 1 is an exploded view of a PC card constructed in accordance with the invention,
Figure 2 illustrates an exploded view of a refinement for the PC card of Figure 1,
Figure 3 is an enlarged cross sectional view of a cover, conductive shield and printed circuit board illustrating in detail the refinement of Figure 2,
Figure 4 illustrates a printed circuit board provided with a more complex conductive shield, and
Figure 5 shows a carrier liner strip provided with shields for use in manufacture of PC cards.

In the drawings the same reference numerals will be employed for similar parts.

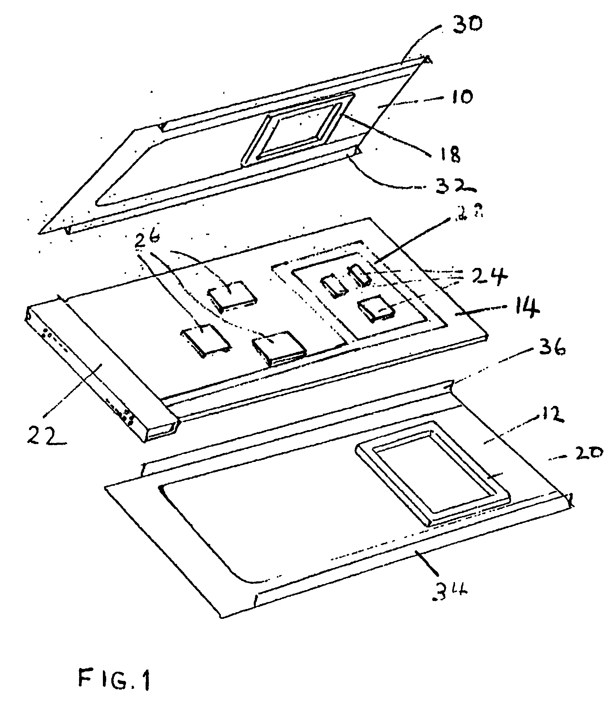

Referring now to Figure 1 there is shown a PC card comprising a two part housing 10, 12 and a printed circuit board 16. The housing is stamped from stainless steel sheet and has a top cover 10 and bottom cover 12. The covers are each provided with a moulded shield 18, 20 in the form of a rectangular walled enclosure. The shield is formed from a conductive elastomer for example CHO-SEAL 1310 of Parker Hannifin plc (CHO-SEAL is a Registered Trade Mark). This material contains silver plated particles and provides excellent electrical conductivity. The shields are secured one to each of the covers in similar dispositions by means of an electrically conductive adhesive for example CHO-BOND 1030 of Parker Hinnifin plc (CHO-BOND is a Registered Trade Mark). This adhesive cures an exposure to air to form a non releasable joint. The printed circuit board has an end connector 22 and is provided with circuit components 24, 26. The components 24 form a circuit which is to be screened to prevent radiation of electromagnetic interference to other circuits on the board e.g. circuits comprising the components 26. The printed circuit board has a grounding track 28 which is arranged to make contact with the shield 18 when the PC card is assembled. To assemble the PC card the board is located in the bottom cover and the top cover is then snapped onto the bottom cover by means of cooperating side walls 30, 32, 34, 36 such that the shield 18 makes electrical contact with the grounding track 28. A similar grounding track or surface may be provided on the opposite side of the board for contact with the shield 20. The shields 18 and 20 may be provided with a releasable conductive adhesive coating such as Parker Hannifin 1085 which would permit the housing to be opened without damage to the shield or printed circuit board. The use of a conductive adhesive to secure the shield permits good electrical conductivity between the shield and the housing and printed circuit grounding track.

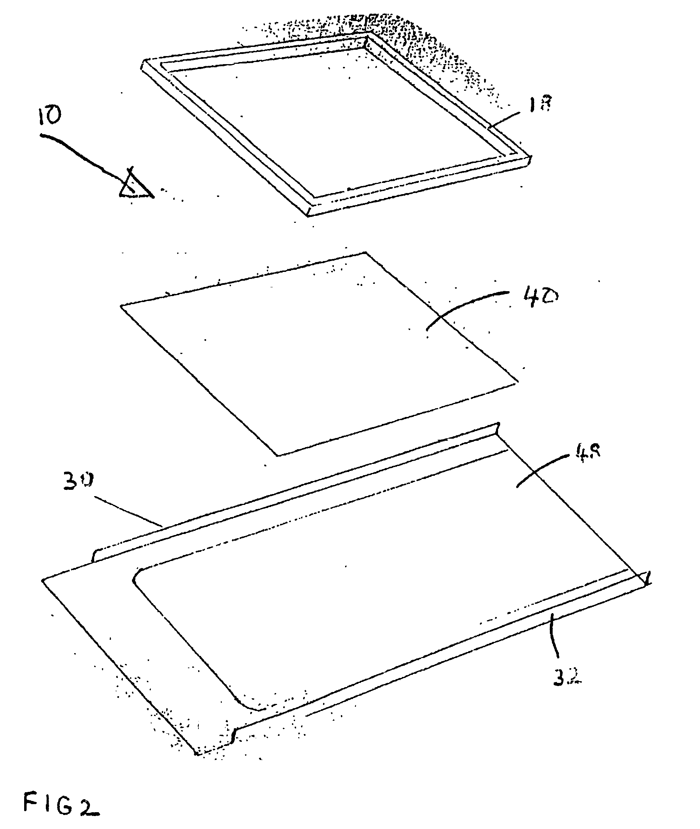

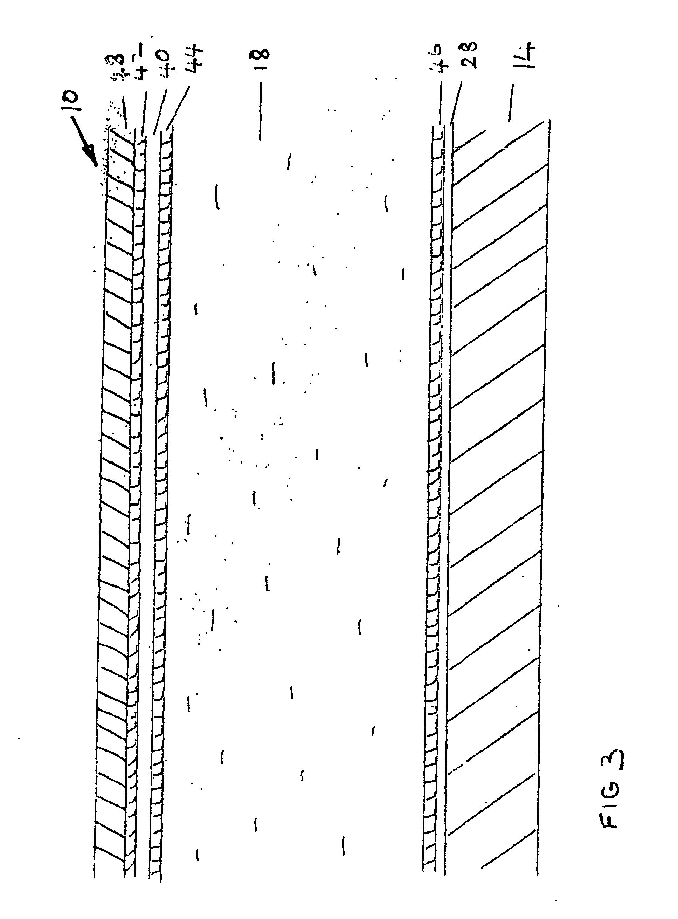

Referring now to Figure 2 there is shown a refinement of the invention and for simplicity only one cover 10 is shown although it is to be understood that the same refinement can be applied to the other cover. In this construction the cover is formed as a sandwich of a sheet metal layer 48 a conductive adhesive layer and a smooth metal foil 40 e.g. copper foil which is coated on both sides with a conductive adhesive such as Parker Hannifin 1085 conductive particle filled acrylic pressure sensitive adhesive previously mentioned. The moulded flexible conductive shield is secured to the foil 40. The foil extends over the whole of one side of the shield and forms the top of a Faraday cage to enhance the screening of the circuity on the printed circuit board. This is because copper is smoother to fix to than the stainless steel of the cover resulting in improved conductivity of the connection between the flexible shield and the foil. Figure 3 illustrates in cross section detail of the connection between the metal layer 48 and the conductive shield 18 via the copper foil, which has a conductive adhesive coating 42, 44 on both sides, and securement of the shield 18 to the grounding track 28 on the printed circuit board 14 by means of a conductive adhesive layer 46.

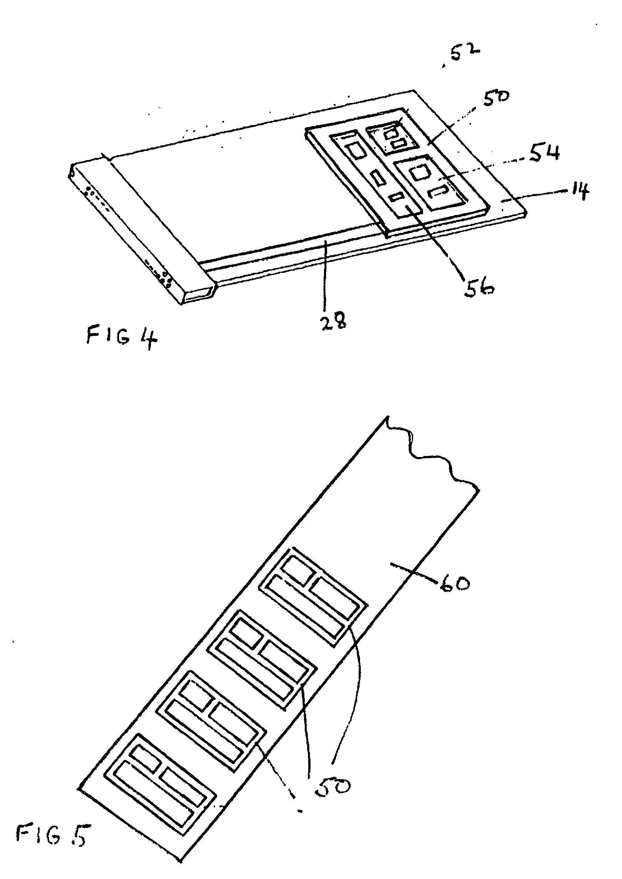

Figure 4 shows a printed circuit board 14 provided with a more complex screen 50 defining three enclosures 52, 54, 56 within which there are provided component of circuits which are to be shielded one from another against electromagnetic interference. The shield is secured to a conductive grounding track 28 on the printed circuit board by a conductive adhesive such as one of the adhesives previously mentioned.

Figure 5 illustrates a carrier strip 60 on which a multiplicity of shields are releasably secured by releasable adhesive. In manufacture this allows the shields to be transferred to a cover or a printed circuit board after application of a conductive adhesive to their exposed surface or after application to the cover or printed circuit board of a conductive adhesive. This permits direct transfer of the shields without damage or distortion and enables automatic application by machine. It will be appreciated that in a construction where a metal foil is employed to enhance the screening such foils could be similarly provided on a carrier strip such as 60 and automatically applied to a shield fitted to a board or cover.

It will be appreciated that a number of alternative constructions and methods of construction of a PC card is possible within the scope of the claims. For example the shield can be permanently secured by a conductive adhesive to the printed circuit board grounding track or to a cover before assembly. Securement to the opposite track or cover can be effected by a permanent setting conductive adhesive or by a releasable conductive adhesive. Both sides could be secured by a releasable conductive adhesive to facilitate replacement of a shield. The adhesive may be applied to the shield or to the track or cover. The adhesive may be applied from a tube just prior to assembly. The conductivity between shield and cover and/or track is ensured without the requirement for compressive pressure. Alternative adhesives can be employed as can different conductive fillers e.g. other metal particles e.g. copper or graphite. Although the embodiments described employ a moulded elastomer for the shield other conductive flexible materials may be employed for example a plated plastics material e.g. polystyrene. The flexible conductive shield could be moulded directly onto the printed board track or cover. Although the embodiments described employ a single shield on each side of the printed circuit board a shield may be provided on one side only or several shields may be provided on one or on both sides of the printed circuit board.

## Claims

1. A PC card, comprising a housing having top (10) and bottom (12) metallic covers, a printed circuit board (14) mounted in the housing and at least one flexible conductive shield (18) provided between and in electrical contact with the board (14) and at least one of the covers (10) and secured by a conductive adhesive to one, or both, of the cover (10) and a corresponding track (28) on the printed circuit board (14).

2. A PC card as claimed in claim 1, wherein the adhesive employed on at least one side of the or each shield is releasable to permit opening of the PC card without damage to the printed circuit board (14) or the shield (18,20).

3. A PC card as claimed in claim 2, wherein the adhesive employed on the opposite side of the or each shield is a permanent non releasable type to maintain securement of the shield.

4. A PC card as claimed in anyone of the preceding claims, wherein the or each shield (18,20) is formed from a conductive elastomer.

5. A PC card as claimed in claim 4, wherein the elastomer contains particles of silver to render it conductive.

6. A PC card as claimed in any one of the preceding claims, wherein the or each shield (18,20) is moulded to define walls providing one or more enclosures for components (24) on the board (14).

7. A PC card as claimed in any one of the preceding claims, wherein at least one of the covers (10,12) is built as a sandwich of a sheet metal layer (48) a conductive adhesive layer (42) and a metal foil (40).

8. A PC card as claimed in claim 7, wherein the metal foil (40) is copper.

9. A method of manufacturing a PC card according to claim 1, comprising the steps of securing the at least one flexible conductive shield (18) to either, or both, of a corresponding track on the printed circuit board (14) and one of the pair of top and bottom metallic covers (10,12) of the housing by means of the conductive adhesive when installing the board in the housing.

10. A method as claimed in claim 9, including the prior step of moulding the or each shield to define walls to provide one or more enclosures for components on the board.

11. A method as claimed in claims 9 or 10, including the steps of providing the conductive adhesive on both sides of a metal toil and securing the or each shield to the cover by attaching one adhesive side to one of the covers and the other adhesive side to the conductive shield.

12. A method as claimed in any one of claims 9 to 11, comprising the steps of releasably attaching the shields on a carrier liner strip from which they are transferred to a cover or printed circuit board during manufacture.

## Patentansprüche

1. PC-Karte, die ein Gehäuse mit einen oberen (10) und einen unteren (12) Metalldeckel, eine gedruckte, in dem Gehäuse montierte Leiterplatte (14) und mindestens eine biegsame, leitende Abschirmung (18), die zwischen, und in elektrischem Kontakt mit, der Platte (14) und mindestens einem der Deckel (10) vorgesehen und mit einem leitenden Klebstoff an einem oder beiden Deckeln (10) und einer entsprechenden Leiterbahn (28) befestigt ist, aufweist.

2. PC-Karte nach Anspruch 1, wobei der auf mindestens einer Seite der oder jeder Abschirmung eingesetzte Klebstoff ablösbar ist, damit sich die PC-Karte ohne Beschädigung der gedruckten Leiterplatte (14) oder der Abschirmung (18, 20) öffnen lässt.

3. PC-Karte nach Anspruch 2, wobei der auf der gegenüber liegenden Seite der oder jeder Abschirmung eingesetzte Klebstoff zur Aufrechterhaltung der Befestigung der Abschirmung ein dauerhafter, nicht ablösbarer Typ ist.

4. PC-Karte nach einem der vorhergehenden Ansprüche, wobei die oder jede Abschirmung (18, 20) aus einem leitenden Elastomer gebildet ist.

5. PC-Karte nach Anspruch 4, wobei das Elastomer Silber-Teilchen enthält, um es leitend zu machen.

6. PC-Karte nach einem der vorhergehenden Ansprüche, wobei die oder jede Abschirmung (18, 20) spritzgegossen wird um Wänden zu definieren, die einen oder mehrere Einschlüsse für Bauteile (24) auf der Platte (14) bilden.

7. PC-Karte nach einem der vorhergehenden Ansprüche, wobei mindestens eine der Abdeckungen (10, 12) als Sandwich von mindestens einer Metallschicht (48), einer leitenden Klebstoffschicht (42) und einer Metallfolie (40) aufgebaut ist.

8. PC-Karte nach Anspruch 7, wobei die Metallfolie (40) Kupfer ist.

9. Verfahren zur Herstellung einer PC-Karte nach Anspruch 1, umfassend die Schritte der Befestigung der mindestens einen biegsamen, leitenden Abschirmung (18) an einem oder beiden von einer entsprechenden Leiterbahn auf der gedruckten Leiterplatte (14) und an einem des Paars von oberem und unterem Metalldeckel (10, 12) des Gehäuses mittels des leitenden Klebstoffs beim Anbringen der Platte in dem Gehäuse.

10. Verfahren nach Anspruch 9, das den vorherigen Schritt des Spritzgießens der oder jeder Abschirmung um Wänden zu definieren, die einen oder mehrere Einschlüsse für Bauteile auf der Platte bilden einschließt.

11. Verfahren nach Anspruch 9 oder 10, das die Schritte des Bereitstellens des leitenden Klebstoffs auf beiden Seiten einer Metallfolie und des Befestigens der oder jeder Abschirmung an dem Deckel durch Anbringen einer Klebstoffseite an einem der Deckel und der anderen Klebstoffseite an der leitenden Abschirmung umfasst.

12. PC-Karte nach einem der Ansprüche 9 bis 11, das die Schritte des wiederablösbaren Anbringens der Abschirmungen auf einem tragenden Unterlagsstreifen, von dem sie während der Herstellung auf einen Deckel oder auf die gedruckte Leiterplatte übertragen werden, umfasst.

## Revendications

1. Carte PC, comprenant un boîtier ayant un couvercle métallique supérieur (10) et un couvercle métallique inférieur (12), une carte à circuits imprimés (14) montée dans le boîtier et au moins un blindage conducteur flexible (18) prévu entre la carte (4) et l'un au moins des couvercles (10), et en contact électrique avec ces derniers, et attaché par un adhésif conducteur à l'un ou aux deux des éléments que sont le couvercle (10) et une piste correspondante (28) sur la carte à circuits imprimés (14).

2. Carte PC selon la revendication 1, dans laquelle l'adhésif employé sur au moins un côté du blindage ou de chaque blindage est libérable pour permettre d'ouvrir la carte PC sans endommager la carte à circuits imprimés (14) ou le blindage (18, 20).

3. Carte PC selon la revendication 2, dans laquelle l'adhésif employé sur le côté opposé du blindage ou de chaque blindage est du type permanent et non libérable pour maintenir l'attachement du blindage.

4. Carte PC selon l'une quelconque des revendications précédentes, dans laquelle le blindage ou chaque blindage (18, 20) est formé en élastomère conducteur.

5. Carte PC selon la revendication 4, dans laquelle l'élastomère contient des particules d'argent pour le rendre conducteur.

6. Carte PC selon l'une quelconque des revendications précédentes, dans laquelle le blindage ou chaque blindage (18, 20) est moulé pour définir des parois qui constituent une ou plusieurs enceintes pour des composants (24) sur la carte (14).

7. Carte PC selon l'une quelconque des revendications précédentes, dans laquelle l'un au moins des couvercles (10, 12) est réalisé à la manière d'un sandwich formé d'une couche de tôle métallique (48), d'une couche adhésive conductrice (42), et d'un film de métal (40).

8. Carte PC selon la revendication 7, dans laquelle le film de métal (40) est en cuivre.

9. Procédé de fabrication d'une carte PC selon la revendication 1, comprenant les étapes consistant à attacher au moins un blindage conducteur flexible (17) sur une piste correspondante de la carte à circuits imprimés (14) ou sur l'un des couvercles d'une paire de couvercles métalliques supérieur et inférieur (10, 12), ou sur les deux, du boîtier au moyen de l'adhésif conducteur lorsqu'on installe la carte dans le boîtier.

10. Procédé selon la revendication 9, comprenant l'étape préalable consistant à mouler le blindage ou chaque blindage pour définir des parois afin de constituer une ou plusieurs enceintes pour des composants sur la carte.

11. Procédé selon l'une ou l'autre des revendications 9 et 10, comprenant les étapes consistant à prévoir l'adhésif conducteur sur les deux côtés d'un film de métal, et à attacher le.blindage
ou chaque blindage sur le couvercle en attachant un côté adhésif à l'un des couvercles et l'autre côté adhésif au blindage conducteur.

12. Procédé selon l'une quelconque des revendications 9 à 11, comprenant l'étape consistant à attacher de façon libérable les blindages sur un ruban de doublage porteur, depuis lequel ils sont transférés à un couvercle ou à une carte à circuits imprimés pendant la fabrication.
